# EUROPÄISCHE PATENTSCHRIFT

(11) **EP 3 956 966 B1**
(45) Veröffentlichungstag und Bekanntmachung des Hinweises auf die Patenterteilung: **26.08.2026**
(21) Anmeldenummer: 20721390.1
(22) Anmeldetag: 16.04.2020
(51) Int. Cl.: H02J 7/00, H01M 10/44, G01R 31/36

(54) **VERFAHREN ZUM SCHUTZ EINER BATTERIEVORRICHTUNG**
METHOD FOR PROTECTING A BATTERY DEVICE
PROCÉDÉ POUR PROTÉGER UN ENSEMBLE BATTERIE

(30) Priorität: 17.04.2019 AT 503502019
(43) Veröffentlichungstag der Anmeldung: 23.02.2022
(73) Patentinhaber: AVL List GmbH, 8020 Graz (AT)
(72) Erfinder: DEIML, Mathias, 93093 Donaustauf (DE); FRIZBERG, Günther, 8051 Graz (AT); GSCHWEITL, Kurt, 8063 Eggersdorf (AT); DHINGRA, Vipul, 8010 Graz (AT)
(74) Vertreter: Mathys & Squire
(86) Internationale Anmeldenummer: PCT/AT2020/060155
(87) Internationale Veröffentlichungsnummer: WO 2020/210853

(56) Entgegenhaltungen:
- US-A1- 2006 170 397
- LEE YONG-DUK ET AL: "Electrochemical State-Based Sinusoidal Ripple Current Charging Control", IEEE TRANSACTIONS ON POWER ELECTRONICS, INSTITUTE OF ELECTRICAL AND ELECTRONICS ENGINEERS, USA, vol. 30, no. 8, 1 August 2015 (2015-08-01), pages 4232 - 4243, XP011574676, ISSN: 0885-8993, [retrieved on 20150305], DOI: 10.1109/TPEL.2014.2354013
- VAZINI HOSSEIN ET AL: "Sinusoidal charging of Li-ion battery based on frequency detection algorithm by pole placement control method", IET POWER ELECTRONICS, IET, UK, vol. 12, no. 3, 20 March 2019 (2019-03-20), pages 421 - 429, XP006083900, ISSN: 1755-4535, DOI: 10.1049/IET-PEL.2018.5626
- BESSMAN ALEXANDER ET AL: "Challenging Sinusoidal Ripple-Current Charging of Lithium-Ion Batteries", IEEE TRANSACTIONS ON INDUSTRIAL ELECTRONICS, IEEE SERVICE CENTER, PISCATAWAY, NJ, USA, vol. 65, no. 6, 1 June 2018 (2018-06-01), pages 4750 - 4757, XP011677210, ISSN: 0278-0046, [retrieved on 20180214], DOI: 10.1109/TIE.2017.2772160

## Beschreibung

Die vorliegende Erfindung betrifft ein Verfahren zum Schutz einer Elektrode einer Batterievorrichtung, eine Kontrollvorrichtung für die Kontrolle einer Batterievorrichtung sowie ein Computerprogrammprodukt für die Durchführung eines solchen Verfahrens.

Es ist bekannt, dass Batterievorrichtungen beim Einsatz einem gewissen Verschleiß und Alterungsprozessen unterliegen. Diese beruhen insbesondere darauf, dass chemische und physikalische Veränderungen an der Elektrode bzw. an den Elektroden der Batterievorrichtung stattfinden. Diese Alterungsprozesse basieren zum Beispiel darauf, dass an einer oder mehreren Elektroden der Batterievorrichtung sich Ablagerungen absetzen. Diese Ablagerungen bilden eine Schicht aus, welche den Übergang von Ionen bzw. Elektronen an der jeweiligen Elektrode hemmt bzw. teilflächig ich sogar gänzlich unterbindet. Je dicker eine solche Schicht auf der jeweiligen Elektrodenoberfläche ausgebildet ist, umso schlechter ist die Wirkungsweise dieser Elektrode und damit der Batterievorrichtung. Über die Nutzungsdauer der Batterievorrichtung steigt die Dicke einer solchen Schicht einer jeweiligen Elektrode an, sodass die Effizienz und die Kapazität der Batterievorrichtung reduziert werden.

Bekannte Lösungen versuchen, den Aufbau dieser Schichten an den Elektroden zu reduzieren bzw. den zeitlichen Bedarf für den Aufbau der Schicht zu erhöhen, sodass die Batterievorrichtung über einen größeren Zeitraum eine höhere Kapazität aufweist. Zum Unterbinden dieser chemischen und physikalischen Alterungsprozesse verwenden bekannte Lösungen insbesondere eine entsprechende Temperierung der Batterievorrichtung. Dies beruht darauf, dass bei unterschiedlichen Temperaturen bei unterschiedlichen Einsatzsituationen unterschiedliche Alterungsgeschwindigkeiten entstehen. Jedoch ist die Verwendung einer gezielten Temperierung relativ aufwendig, da hierfür ebenfalls Energie aufgewendet werden muss. Befindet sich eine Batterievorrichtung in einem Fahrzeug, wird also ein Teil der Energie nicht der Antriebsleistung bzw. der Nutzungsleistung zur Verfügung gestellt, da sie als Schutzleistung für das Temperieren der Batterievorrichtung erforderlich ist. Dies gilt nicht nur für eine Betriebssituation der Batterievorrichtung, sondern auch für eine Lagersituation der Batterievorrichtung. Darüber hinaus sind die Schutzmechanismen solcher Temperiermöglichkeiten begrenzt.

Die Druckschrift LEE YONG-DUK ET AL: "Electrochemical State-Based Sinusoidal Ripple Current Charging Control", IEEE TRANSACTIONS ON POWER ELECTRONICS, INSTITUTE OF ELECTRICAL AND ELECTRONICS ENGINEERS, USA, Bd. 30, Nr. 8, 1. August 2015 (2015-08-01), Seiten 4232-4243, XP011574676, ISSN: 0885-8993, DOI: 10.1109/TPEL.2014.2354013 offenbart einen Algorithmus zur Aufladung mit einem sinusförmigen Ripplestrom auf der Grundlage von Impedanzmessungen.

Die Druckschrift VAZINI HOSSEIN ET AL: "Sinusoidal charging of Li-ion battery based on frequency detection algorithm by pole placement control method", IET POWER ELECTRONICS, IET, UK, Bd. 12, Nr. 3, 20. März 2019 (2019-03-20), Seiten 421-429, XP006083900, ISSN: 1755-4535, DOI: 10.1049/IET-PEL.2018.5626 beschreibt ein Kontrollsystem zur Verfolgung des sinusförmigen Ripplestroms (SRC) von Lithium (Li)-Ionen-Batterien. In die Batterien wird eine Kombination aus einem Gleichstrom und einem sinusförmigen Ripplestrom eingespeist.

Die Druckschrift US 2006/0170397 A1 offenbart einen Batterie-Gesundheitsmonitor (BHM), der als Batterie montierbares Vollspektrum-Wechselstrom-Impedanzmessgerät dient, und der die Überwachung des Ladezustands und des Gesundheitszustandes einer Batterie ermöglicht.

Die Druckschrift BESSMAN ALEXANDER ET AL: "Challenging Sinusoidal Ripple-Current Charging of Lithium-Ion Batteries", IEEE TRANSACTIONS ON INDUSTRIAL ELECTRONICS, IEEE SERVICE CENTER, PISCATAWAY, NJ, USA, Bd. 65, Nr. 6, 1. Juni 2018 (2018-06-01), Seiten 4750-4757, XP011677210, ISSN: 0278-0046, DOI: 10.1109/TIE.2017.2772160 beschreibt Studien zur sinusförmigen Rippelstromladung, Ladungseffizienz, Energieeffizienz und Ladungszeit bei Lithium-Ionen-Batterien.

Es ist Aufgabe der vorliegenden Erfindung, die voranstehend beschriebenen Nachteile zumindest teilweise zu beheben. Insbesondere ist es Aufgabe der vorliegenden Erfindung, in kostengünstiger und einfacher Weise einen verbesserten Schutz für die Elektroden einer Batterievorrichtung zur Verfügung zu stellen.

Die voranstehende Aufgabe wird gelöst durch ein Verfahren mit den Merkmalen des Anspruchs 1, eine Kontrollvorrichtung mit den Merkmalen des Anspruchs 13 und ein Computerprogrammprodukt mit den Merkmalen des Anspruchs 15. Weitere Merkmale und Details der Erfindung ergeben sich aus den Unteransprüchen, der Beschreibung und den Zeichnungen. Dabei gelten Merkmale und Details, die im Zusammenhang mit dem erfindungsgemäßen Verfahren beschrieben sind, selbstverständlich auch im Zusammenhang mit der erfindungsgemäßen Kontrollvorrichtung und dem erfindungsgemäßen Computerprogrammprodukt und jeweils umgekehrt, sodass bezüglich der Offenbarung zu den einzelnen Erfindungsaspekten stets wechselseitig Bezug genommen wird bzw. werden kann.

Erfindungsgemäß dient ein Verfahren zum Schutz einer Elektrode einer Batterievorrichtung. Hierfür weist dieses Verfahren die folgenden Schritte auf:
- Bestimmen wenigstens eines elektrischen Batterieparameters der Batterievorrichtung, um eine jeweilige Batteriesituation der Batterievorrichtung zu bestimmen,
- Bestimmen eines Betriebsparameters eines Betriebsstroms der Batterievorrichtung,
- Ermitteln eines Störparameters für einen Störstrom auf Basis des Betriebsparameters,
- Erzeugen des Störstroms,
- Beaufschlagen des Betriebsstroms mit dem Störstrom zum Anlegen an die Elektrode, um einen Alterungsprozess an der Elektrode zu hemmen oder um zumindest eine Geschwindigkeit einer Alterung der Elektrode zu reduzieren.

Bei dem erfindungsgemäßen Verfahren erfolgt für die Ermittlung des Störparameters ein Vergleich der realen Impedanz und der imaginären Impedanz der Batterievorrichtung. Unter der realen Impedanz ist die reale Impedanz der Batterievorrichtung in der jeweiligen Situation zu verstehen. Die imaginäre Impedanz basiert auf der jeweiligen Simulation der Batterievorrichtung in der jeweiligen Batteriesituation. Durch die Korrelation der realen Impedanz und der imaginären Impedanz kann ein zusätzlicher Einfluss genommen werden auf die Ermittlung des Störparameters. Insbesondere wird es auf diese Weise möglich, den Störparameter noch genauer an die aktuelle Batteriesituation anzupassen, sodass die chemischen und/oder physikalischen Schutzmechanismen beim Einbringen des Störstroms noch zielgerichteter und noch effektiver erreicht werden können.

Ein erfindungsgemäßes Verfahren baut darauf auf, dass auch die Betriebsweise des jeweiligen Betriebsstroms Auswirkungen auf die Batterievorrichtung, insbesondere auf die Elektrode oder andere Komponenten der Batterievorrichtung und deren Alterungsprozesse hat. So wird, je nachdem welche Stromsituation an der Elektrode vorliegt, sich eine entsprechende Alterungssituation auf Basis dieser Stromsituation einstellen. Erfindungsgemäß wird also nun diese Stromsituation bestimmt, indem zumindest ein Betriebsparameter eines Betriebsstroms bestimmbar ist. Um diesen Betriebsparameter und den Betriebsstrom an die jeweilige Betriebssituation der Batterievorrichtung anzupassen, ist erfindungsgemäß vorgelagert, noch einen Bestimmungsschritt eines elektrischen Batterieparameters der Batterievorrichtung vorgesehen.

Unter dem Bestimmen wenigstens eines elektrischen Batterieparameters ist insbesondere eine grundsätzliche Bestimmung der Batteriesituation der Batterievorrichtung zu verstehen. So kann der elektrische Batterieparameter zum Beispiel eine Information enthalten, ob sich die Batterievorrichtung aktuell in einem Ladezustand oder in einem Entladezustand befindet. Auch kann ein Haltezustand außerhalb einer Nutzung der Batterievorrichtung als elektrischer Batterieparameter definiert sein. Zusätzlich oder alternativ sind auch weitere Batterieparameter, wie zum Beispiel der Ladungszustand, auch State of Charge (SOC) genannt, der Alterungszustand, auch genannt State of Health (SOH) oder Ähnliches im Sinne der vorliegenden Erfindung denkbar. Die Bestimmung des Batterieparameters erlaubt es also, das erfindungsgemäße Verfahren auf Basis der aktuellen Batteriesituation umzusetzen oder sogar anzupassen.

Ein erfindungsgemäßer Kerngedanke liegt darin, nun zusätzlich zu dem aktuellen Betriebsstrom einen Störstrom zu erzeugen. Dieser Störstrom ist abhängig von dem Betriebsstrom, da er sich bewusst in Hinsicht zumindest eines Stromparameters von dem Betriebsstrom unterscheidet. Dabei handelt es sich zum Beispiel um den Wechselstromanteil als Stromparameter mit den Einzelparametern Amplitude und Frequenz addiert. Um diese Unterscheidung zur Verfügung zu stellen, und insbesondere eine Anpassung des Störstroms an den Betriebsstrom zu ermöglichen, sind ein Bestimmungsschritt und ein Ermittlungsschritt im Sinne der vorliegenden Erfindung notwendig. Zum einen muss bei laufender Batterievorrichtung zumindest ein Betriebsparameter des Betriebsstroms bestimmt werden. Bei dem Betriebsparameter des Betriebsstroms handelt es sich um einen Stromparameter des Betriebsstroms. Zum Beispiel können als Betriebsparameter die Stromamplitude und/oder die Stromfrequenz des Betriebsstroms bestimmt werden. Auf Basis dieses bestimmten Betriebsparameters wird nun zumindest ein Störparameter für einen Störstrom ermittelt. Dieses Ermitteln bezieht sich insbesondere auf identische oder im Wesentlichen identische Stromparameter, sodass auch der Störparameter zum Beispiel eine Stromamplitude und/oder eine Stromfrequenz für den Störstrom zur Verfügung stellen kann.

Der Störstrom wird anschließend auf Basis des ermittelten Störparameters erzeugt, sodass abschließend der Betriebsstrom mit dem Störstrom beaufschlagt werden kann.

Erfindungsgemäß stellt sich also bei der Durchführung eines erfindungsgemäßen Verfahrens in der Batterievorrichtung nun zusätzlich zu dem Betriebsstrom eine Beaufschlagung des Störstroms ein. Dies führt in Summe zu einer Überlagerung des Betriebsstroms mit dem Störstrom. Solche Störströme können grundsätzlich auch als sogenannte Rippelströme bezeichnet werden. Während bei bekannten Batterievorrichtungen und den entsprechenden Kontrollverfahren solche Rippelströme unerwünscht sind, werden sie bei einem erfindungsgemäßen Verfahren bewusst und zielgenau eingesetzt. Durch das Ausbilden eines Störstroms können insbesondere in chemischer und/oder in physikalischer Weise Vorteile erzielt werden, welche den Alterungsprozess an der Elektrode der Batterievorrichtung hemmen oder zumindest die Geschwindigkeit der Alterung reduzieren.

So ist es zum Beispiel möglich, über eine Störung des Betriebsstroms durch veränderten Störstrom hinsichtlich einer veränderten Stromamplitude und/oder einer veränderten Stromfrequenz eine disharmonische Situation aus chemischer Sicht für die einzelnen lonenübergänge an der Elektrode zur Verfügung zu stellen. Mit anderen Worten löst sich ein kontinuierlicher Stromübergang an der Elektrode auf und geht in einen diskontinuierlichen Stromübergang und damit einen lonenübergang an der Elektrode über. Diese diskontinuierliche Ausbildung, welche insbesondere wellenförmig und damit schubweise die Elektronen an der Elektrode aufbringt bzw. wieder abzieht, führt dazu, dass eine lonenstausituation an der Elektrode vermieden werden kann. Damit wird durch die disharmonische Übertragung von Elektronen an der jeweiligen Elektrode der Batterievorrichtung der Aufbau einer Schicht an der Elektrode erschwert oder zumindest zeitweise sogar gänzlich verhindert.

Neben dem voranstehend beschriebenen Effekt sind auch weitere physikalische Effekte denkbar, welche durch den Störstrom an der jeweiligen Elektrode erzeugt werden können. Dabei handelt es sich zum Beispiel um die tatsächliche Positionierung der einzelnen Ionen, welche beim Übergang an die Elektrode nun durch den Störstrom weniger Ablagerungswahrscheinlichkeit zur Verfügung stellen können. Dies führt im Ergebnis dazu, dass durch die Überlagerung des Störstroms und des Betriebsstroms eine reduzierte Alterungsgeschwindigkeit an der Elektrode erzielt werden kann. Neben den physikalischen Effekten sind auch chemische Effekte denkbar. Dabei handelt es sich zum Beispiel um den Einfluss des Störstroms auf die Bildung einer Schichtablagerung auf der Elektrode. Dies ist insbesondere bei hohen und/oder tiefen Temperaturen der Fall, da eine Inaktivierung von Lithium Ionen gebremst wird.

Wie aus der voranstehenden Erläuterung ersichtlich wird, kann auf verschiedenste Effekte Rücksicht genommen werden, und auf diese Weise die Alterungsgeschwindigkeit der Elektrode der Batterievorrichtung reduziert oder sogar teilweise gehemmt werden. Dies führt darauf zurück, dass nun erfindungsgemäß der Betriebsstrom mit einem definierten Störstrom überlagert wird. Dieser Störstrom ist dabei nicht wahllos erzeugt, sondern basiert auf der aktuellen Situation des Betriebsstroms, sodass ein Störparameter den Störstrom an die jeweilige Betriebssituation anpassen kann. Bevorzugt wird bei der Ermittlung des Störparameters auch darüber hinaus, der bereits bestimmte wenigstens eine elektrische Batterieparameter der Batterievorrichtung mit einbezogen. Insbesondere ist der Störparameter dabei unterschiedlich von dem Betriebsparameter des jeweiligen Betriebsstroms.

Es kann Vorteile mit sich bringen, wenn bei einem erfindungsgemäßen Verfahren der Störparameter sich von dem Betriebsparameter unterscheidet und insbesondere einen der folgenden Stromparameter aufweist:
- Stromamplitude
- Stromfrequenz

Bei der voranstehenden Aufzählung handelt es sich um eine nicht abschließende Liste. Selbstverständlich können auch zwei oder mehr solcher Parameter gemeinsam in einem Störparameter kombiniert werden oder aber eine Mehrzahl von Störparametern und Betriebsparametern Verwendung finden. Die Unterscheidung von Störparameter und Betriebsparameter hinsichtlich des quantitativen Zahlenwerts unterstützt die erfindungsgemäße Störfunktion, wie sie ausführlich erläutert worden ist. Durch die Unterscheidung zumindest in einem Betriebsparameter und Störparameter kann eine resultierende Stromsituation erzeugt werden, welche sich von der Betriebssituation bei ausschließlich eingesetztem Betriebsstrom unterscheidet. Die in der Einleitung erläuterten Effekte aus chemischer und physikalischer Sicht können auf diese Weise zielgenau und vorzugsweise in vordefinierter Weise erzielt werden. Auf diese Weise kann zum Beispiel aktiv ein sogenannter Rippelstrom hinsichtlich disharmonischer oder asymmetrischer Frequenz und entsprechend unterschiedlicher Amplitude zur Verfügung gestellt werden.

Ein weiterer Vorteil kann erzielt werden, wenn bei einem erfindungsgemäßen Verfahren die Bestimmung des wenigstens einen Betriebsparameters und/oder des wenigstens einen elektrischen Batterieparameters auf Basis von zumindest einem gemessenen Sensorwert erfolgt. So kann beispielsweise eine Sensorvorrichtung vorgesehen sein, welche in der Lage ist, einen Sensorwert in direkter oder indirekter Weise zu bestimmen. Im einfachsten Fall kann ein solcher Sensorwert eine Aussage darüber treffen, in welchem Betriebszustand sich die Batterievorrichtung befindet. Zum Beispiel kann der Ladezustand von einem Entladezustand der Batterievorrichtung definiert werden. Eine solche Sensorik kann direkt an der Batterievorrichtung oder aber an anderer Stelle in der Nutzungssituation, zum Beispiel in einem Fahrzeug, angeordnet sein. Der entsprechende Sensorwert kann darüber hinaus auch für die Bestimmung des Betriebsparameters eingesetzt werden, zum Beispiel durch entsprechende Messung der einzelnen Stromparameter des Betriebsstroms.

Ebenfalls Vorteile bringt es mit sich, wenn bei einem erfindungsgemäßen Verfahren die Bestimmung des wenigstens einen Betriebsparameters und/oder des wenigstens einen elektrischen Batterieparameters zumindest teilweise auf Basis eines Simulationsmodells erfolgt. Ein Simulationsmodell ist insbesondere ein mathematisches bzw. computerbasiertes Simulationsmodell. Eine solche Verwendung eines Simulationsmodels erlaubt es auch, komplexere Möglichkeiten zu berücksichtigen, als sie bei der Berücksichtigung reiner Sensorwerte möglich wären. Simulationsmodelle können zum Beispiel durch Prüfstände der Batterievorrichtung ermittelt bzw. erzeugt werden. Auch die Verwendung großer Datensätze und das rein mathematische Erzeugen eines Simulationsmodells sind im Rahmen der vorliegenden Erfindung selbstverständlich denkbar. Auch können grundsätzlich Sensorwert und Simulationsmodelle in Kombination bei einem erfindungsgemäßen Verfahren eingesetzt werden. Ein solches Simulationsmodell kann als rein numerisches Modell, aber auch als flexibles Modell, zum Beispiel unter Verwendung von künstlicher Intelligenz und damit unter Verwendung sogenannter neuronaler Netze, eingesetzt werden.

Weitere Vorteile bringt es mit sich, wenn bei einem erfindungsgemäßen Verfahren der Störparameter eine Stromfrequenz des Störstroms aufweist, welche insbesondere kleiner oder im Wesentlichen kleiner als 1 kHz ist. Der Störparameter weist dabei vorzugsweise eine Stromfrequenz auf, welche darüber hinaus größer ist als eine entsprechende Betriebsfrequenz als Betriebsparameter des Betriebsstroms. Die höchste Frequenz liegt dabei insbesondere in einem Hochfrequenzbereich für den Störparameter zwischen zum Beispiel ca. 0,5 kHz und ca. 1 kHz. Dabei ist für den Störparameter die Stromfrequenz des Störstroms insbesondere unabhängig von der Amplitude des Störstroms ausgebildet.

Darüber hinaus bringt es Vorteile mit sich, wenn bei einem erfindungsgemäßen Verfahren gemäß dem voranstehenden Absatz beim Vergleich ein Bereich eines lokalen Minimums ausgewählt wird für die Ermittlung des Störparameters, insbesondere in Form einer Stromfrequenz. Ein solches lokales Minimum ist insbesondere auch als absolutes Minimum ausgebildet. Bei unterschiedlichen Frequenzbereichen befindet sich eine Impedanzkurve bei dieser Ausgestaltung in unterschiedlichen Korrelationen zwischen realer Impedanz und imaginärer Impedanz. Die Auswahl eines lokalen Minimums der imaginären Impedanz über der realen Impedanz führt dazu, dass ein erfindungsgemäßer Vorteil hinsichtlich der chemischen und physikalischen Schutzweise weiter und in verbesserter Weise erzielbar wird.

Auch vorteilhaft kann es sein, wenn bei einem erfindungsgemäßen Verfahren nach einem der voranstehenden beiden Absätze für den Vergleich der realen Impedanz mit der imaginären Impedanz der Batterievorrichtung eine für den bestimmten Batterieparameter und/oder den bestimmten elektrischen Betriebsparameter spezifische Impedanzkurve verwendet wird. Wie bereits einleitend erläutert wird, kann auch auf diese Weise eine Anpassung des erfindungsgemäßen Verfahrens an die aktuelle Betriebssituation der Batterievorrichtung erfolgen. So können unterschiedliche Impedanzkurven zum Beispiel den Ladezustand von dem Entladezustand der Batterievorrichtung unterscheiden. Jedoch sind auch unterschiedliche Stromstärken und Stromfrequenzen denkbar, welche zu unterschiedlichen Impedanzkurven führen und damit einen unterschiedlichen Einfluss auf das Vergleichsergebnis bei dieser Ausführungsform haben. Die unterschiedlichen Impedanzkurven können zum Beispiel auch als Simulationsmodell zur Verfügung gestellt sein, und vorzugsweise durch Prüfstandsversuche erzeugt werden. Ein solches Set von zwei oder mehr Impedanzkurven führt also dazu, dass das erfindungsgemäße Verfahren noch genauer und noch spezifischer die erfindungsgemäße Schutzvorteile für die Elektrode erzielen kann.

Vorteilhaft ist es weiter, wenn bei einem erfindungsgemäßen Verfahren bei der Ermittlung des Störparameters wenigstens eine absolute Grenze eingehalten wird. Eine solche absolute Grenze ist insbesondere eine absolute Obergrenze. Jedoch ist zusätzlich oder alternativ auch eine absolute Untergrenze im Sinne der vorliegenden Erfindung denkbar. Bevorzugt wird durch zumindest zwei absolute Grenzen ein Grenzkorridor zur Verfügung gestellt, innerhalb welchem sich der jeweilige Störparameter befinden soll. Werden zwei oder mehr Störparameter, zum Beispiel eine Störfrequenz und eine Störamplitude verwendet, so kann selbstverständlich für jeden dieser Störparameter eine entsprechende Grenzausgestaltung vorgesehen sein. Dies führt dazu, dass zum einen unerwünschte Nebeneffekte und vor allem auch Beschädigungseffekte bei zu großen Störparametern eingegrenzt oder sogar gänzlich ausgeschlossen werden können.

Ebenfalls vorteilhaft ist es, wenn bei einem erfindungsgemäßen Verfahren gemäß dem voranstehenden Absatz als absolute Grenze für einen Störparameter in Form einer Stromamplitude als Obergrenze die Hälfte, insbesondere ein Drittel der aktuellen Stromamplitude des Betriebsstroms verwendet wird. Das bedeutet also, dass die Stromstärke für den Störstrom geringer ist als die Stromstärke für den Betriebsstrom. Dies führt unter anderem dazu, dass durch die Kombination von Betriebsstrom und Störstrom die maximale Amplitude als kombinierte Amplitude vor zu hoher Belastung der einzelnen Bauteile der Batterievorrichtung schützt. Es erlaubt es darüber hinaus, eine Optimierung zwischen Betriebsschutz und Elektrodenschutz zur Verfügung zu stellen. Selbstverständlich kann hier neben einem reinen Steuerverfahren auch ein Regelungsverfahren eingesetzt werden, um im Ergebnis die Kombinationsamplitude zu überwachen und nachregeln zu können.

Ein weiterer Vorteil ist erzielbar, wenn bei einem erfindungsgemäßen Verfahren für die Erzeugung des Störstroms wenigsten ein elektrisches Sekundärbauteil mit eigenem Strombedarf im Stromkreis der Batterievorrichtung eingesetzt wird. Ein solches Sekundärbauteil ist also ein elektrischer Verbraucher, welcher im Stromkreis der Batterievorrichtung eingesetzt wird. Dies können Standardverbraucher sein oder Verbraucher, welche explizit für ein erfindungsgemäßes Verfahren vorgesehen sind. Bevorzugt ist jedoch die Verwendung von bestehenden Verbrauchern und insbesondere von Verbrauchern, welche in der jeweiligen Situation auch tatsächlich genutzt werden. Somit kann ohne zusätzlichen Strombedarf die Nutzung eines bestehenden Verbrauchers ausreichen, um den entsprechenden Störstrom zur Verfügung zu stellen. Mit anderen Worten wird das jeweilige, insbesondere aktive, Sekundärbauteil als Erzeugungsmodul ausgewählt, um auf Basis des ermittelten Störparameters den Störstrom zu erzeugen und durch die Ausbildung im Stromkreis der Batterievorrichtung auf diese zu beaufschlagen. Selbstverständlich wird bei der Erzeugung des Störparameters und damit bei der Erzeugung des Störstroms die jeweilige Grenzbelastung dieses erzeugenden Sekundärbauteils berücksichtigt, um unerwünschte Beschädigungen oder nachteilhafte Beeinflussungen am Sekundärbauteil zu vermeiden oder zumindest so gering wie möglich zu halten.

Vorteilhaft ist es, wenn bei einem Verfahren gemäß dem voranstehenden Anspruch als Sekundärbauteil ein Inverter des Stromkreises der Batterievorrichtung verwendet wird. Ein besonders großer Vorteil ist die entsprechend große Leistung des Inverters, sodass eine große Bandbreite zur Verfügung steht, um unterschiedlichste Störströme hinsichtlich Störparameter in Form der Stromamplitude und/oder der Stromfrequenz zu erzeugen. Schädigungsfrequenzen und Schädigungsamplituden werden, wie dies im voranstehenden Absatz bereits erläutert worden ist, auch in diesem Fall für den Inverter vermieden.

Weiterer Vorteile sind erzielbar, wenn bei einem erfindungsgemäßen Verfahren wenigstens zwei Sekundärbauteile wenigstens teilweise zeitlich parallel für das Erzeugen des Störstroms verwendet werden. Eine zumindest teilweise zeitliche Überlappung führt dazu, dass die Sekundärbauteile während der zeitlichen Überlappung eine größere Bandbreite zur Verfügung stellen können, um den jeweiligen Störstrom anzupassen und zur Verfügung zu stellen. Dies bezieht sich insbesondere auf die maximal mögliche Amplitude und/oder Frequenz des Störstroms. Selbstverständlich können auch komplett nachgelagert und ohne zeitliche Überlappung zwei oder mehr Sekundärbauteile ein erfindungsgemäßes Verfahren durchführen.

Weiterer Vorteile können erzielt werden, wenn bei einem erfindungsgemäßen Verfahren die wenigstens zwei Sekundärbauteile mit synchronem oder im Wesentlichen synchronem Störstrom betrieben werden. Das bedeutet also, dass eine additive Wirkung zur Verfügung gestellt wird, welche insbesondere auf eine vergrößerte Stromamplitude des Störstroms hinwirkt. Die Kombination von synchron betriebenen Sekundärbauteilen führt sozusagen zu einer gemeinsamen Verstärkung des Störstroms und kann bei geringer Leistung des einzelnen Sekundärbauteils die gewünschte Stromstärke als Amplitude für den Störstrom zur Verfügung stellen.

Ebenfalls vorteilhaft kann es sein, wenn bei einem erfindungsgemäßen Verfahren die wenigstens zwei Sekundärbauteile mit asynchronem oder im Wesentlichen asynchronem Störstrom betrieben werden. Dies kann auch als die Ausbildung von zwei unterschiedlichen Störströmen verstanden werden, welche gemeinsam auf den Betriebsstrom beaufschlagt werden. Es entsteht also sozusagen ein doppelter Störstrom bzw. ein doppelter Rippelstrom. Dies dient insbesondere zur Störung der jeweiligen Frequenz, um eine überlagerte Schutzwirkung zur Verfügung zu stellen. Hinsichtlich der chemischen und hinsichtlich der physikalischen Schutzwirkung können die beschriebenen Vorteile dabei noch weiter verstärkt werden.

Ebenfalls Gegenstand der vorliegenden Erfindung ist eine Kontrollvorrichtung für eine Kontrolle einer Batterievorrichtung in erfindungsgemäßer Weise. Eine solche Kontrollvorrichtung weist ein Bestimmungsmodul zum Bestimmen wenigstens eines elektrischen Batterieparameters der Batterievorrichtung, um eine jeweilige Batteriesituation der Batterievorrichtung zu bestimmen, und zum Bestimmen eines Betriebsparameters eines Betriebsstroms der Batterievorrichtung auf. Weiter ist ein Ermittlungsmodul zum Ermitteln eines Störparameters für einen Störstrom auf Basis des Betriebsparameters vorgesehen, wobei für die Ermittlung des Störparameters ein Vergleich der realen Impedanz der Batterievorrichtung in der jeweiligen Batteriesituation und der imaginären Impedanz basierend auf einer jeweiligen Simulation der Batterievorrichtung in der jeweiligen Batteriesituation erfolgt. Die Kontrollvorrichtung ist weiter mit einem Erzeugungsmodul zum Erzeugen des Störstroms und einem Beaufschlagungsmodul für ein Beaufschlagen des Betriebsstroms mit dem Störstrom zum Anlegen an eine Elektrode der Batterievorrichtung, um einen Alterungsprozess an der Elektrode zu hemmen oder um zumindest eine Geschwindigkeit einer Alterung der Elektrode zu reduzieren, ausgestattet. Erfindungsgemäß sind das Betriebsmodul, das Ermittlungsmodul, das Erzeugungsmodul und das Beaufschlagungsmodul für die Durchführung eines erfindungsgemäßen Verfahrens ausgebildet. Damit bringt eine erfindungsgemäße Kontrollvorrichtung die gleichen Vorteile mit sich, wie sie ausführlich mit Bezug auf ein erfindungsgemäßes Verfahren erläutert worden sind. Eine solche Kontrollvorrichtung kann zum Beispiel bei stationären Batterievorrichtungen eingesetzt werden. Jedoch ist grundsätzlich auch ein Einsatz bei mobilen Batterievorrichtungen, insbesondere bei Batterievorrichtungen in Fahrzeugen denkbar. Nicht zuletzt kann eine solche Kontrollvorrichtung auch an einem Prüfstand einer Batterievorrichtung eingesetzt werden, um zum Beispiel die bereits erläuterten Simulationsmodelle zu erzeugen.

Ein weiterer Gegenstand der vorliegenden Erfindung ist ein Computerprogrammprodukt, umfassend Befehle, die bei der Ausführung des Programms durch einen Computer diesen veranlassen, das Verfahren gemäß der vorliegenden Erfindung durch die Kontrollvorrichtung auszuführen. Damit bringt ein erfindungsgemäßes Computerprogrammprodukt die gleichen Vorteile mit sich, wie sie ausführlich mit Bezug auf ein erfindungsgemäßes Verfahren erläutert worden sind.

Weiterer Vorteile, Merkmale und Einzelheiten der Erfindung ergeben sich aus der nachfolgenden Beschreibung, in der unter Bezugnahme auf die Zeichnungen Ausführungsbeispiele der Erfindung im Einzelnen beschrieben sind. Es zeigen schematisch:
- Figur 1: eine Ausführungsform einer erfindungsgemäßen Batterievorrichtung,
- Figur 2: eine Situation mit Betriebsstrom,
- Figur 3: eine Situation mit Störstrom,
- Figur 4: eine Ausführungsform einer erfindungsgemäßen Kontrollvorrichtung und
- Figur 5: eine Möglichkeit einer Impedanzkurve.

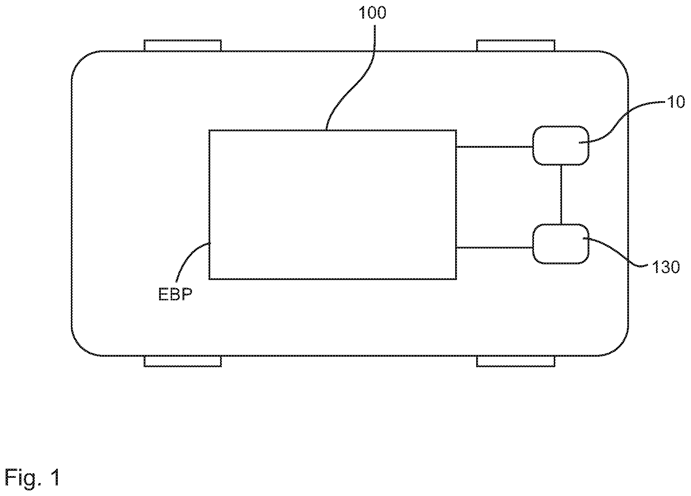

In der Figur 1 ist schematisch als Beispiel einer Nutzung einer Batterievorrichtung 100 ein Fahrzeug dargestellt. Die Batterievorrichtung 100 weist dabei viele einzelne Batteriezellen auf, welche jeweils mit zwei Elektroden ausgestattet sind. Je nachdem, in welchem Betriebsmodus sich das Fahrzeug und damit auch die Batterievorrichtung 100 befindet, kann der Batterievorrichtung 100 ein Batterieparameter EBP zugeordnet werden. Dabei kann es sich zum Beispiel um einen Ladezustand, einen Entladezustand, einen aktuellen Ladungszustand (SOC) oder zum Beispiel einen Alterungszustand (SOH) handeln. Für die Überwachung der Batterievorrichtung 100 ist hier schematisch eine Kontrollvorrichtung 10 dargestellt sowie zumindest ein Sekundärbauteil 130 im Stromkreis der Batterievorrichtung 100. Das Sekundärbauteil 130 kann ein elektrischer Verbraucher, zum Beispiel in Form eines Inverters für die Batterievorrichtung 100 sein.

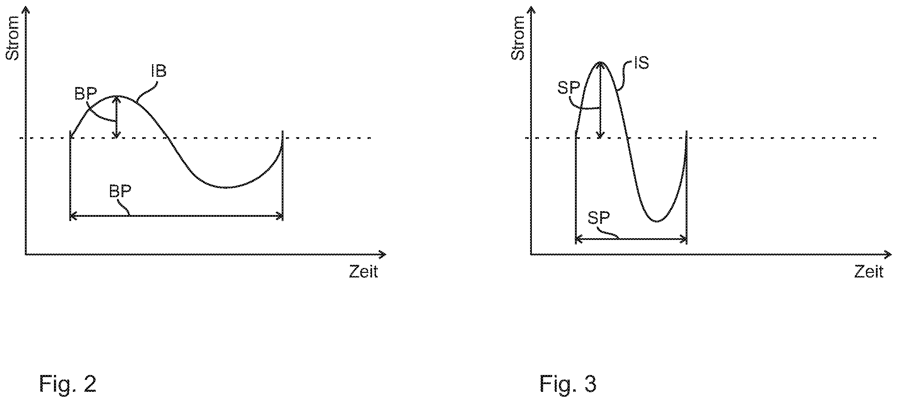

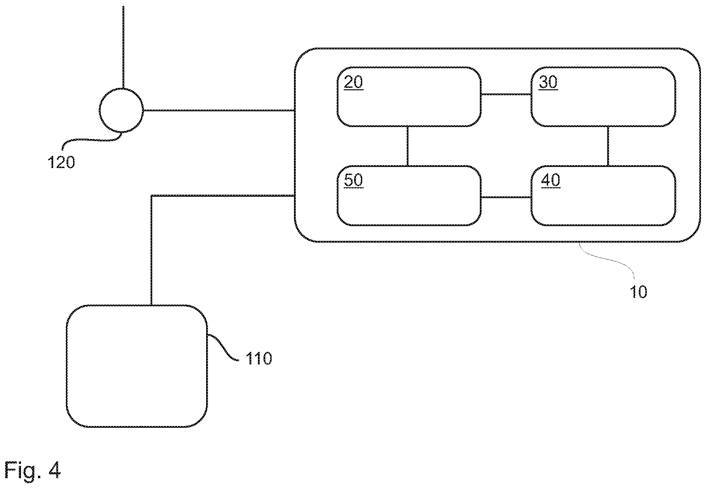

Die Figuren 2 und 3 zeigen schematisch die grundsätzlichen Kerngedanken der Funktionsweise eines erfindungsgemäßen Verfahrens. Ausgehend von der Batterievorrichtung 100 der Figur 1 kann nun mit der Kontrollvorrichtung 10 ein Bestimmungsschritt durchgeführt werden. Das Bestimmungsmodul 20, wie es zum Beispiel in der Figur 4 dargestellt ist, wird nun in einem ersten Schritt den elektrischen Batterieparameter EBP der Batterievorrichtung 100 bestimmen. Anschließend erfolgt ein Bestimmungsschritt für den Betriebsparameter BP oder zumindest einen Betriebsparameter BP des Betriebsstroms IB. Dies ist schematisch in der Figur 2 dargestellt. In der Figur 2 ist eine Periode einer Stromfrequenz des Betriebsstroms IB dargestellt. Der Betriebsstrom IB kann hier insbesondere hinsichtlich zwei Stromparametern Betriebsparameter BP aufweisen.

Dabei handelt es sich zum einen um die halbe Amplitudengröße im positiven Sinn des Betriebsstroms IB. Weiter ist die Frequenz, also die Länge einer Periode des Betriebsstroms IB hier als Betriebsparameter BP schematisch dargestellt. Einer oder beide oder sogar weitere Kombinationen von Stromparametern des Betriebsstroms IB können nun durch das Bestimmungsmodul 20 bestimmt werden und dem weiteren Verfahren zugrunde gelegt werden.

Die Figur 3 zeigt, wie nun auf Basis des Betriebsstroms IB und der bestimmten Betriebsparameter BP ein Störparameter SP zur Verfügung gestellt wird. Dieses Erzeugen des Störparameters SP basiert bei dieser Ausführungsform auf eine Erzeugung von unterschiedlichen Stromparametern im Vergleich zum Betriebsstrom IB. Beim Beispiel der Figur 3 führt dies dazu, dass zum einen eine größere Amplitude als erster Störparameter SP und eine kürzere Frequenz bzw. Länge der Periode als zweiter Störparameter SP erzeugt werden. Auf Basis dieser beiden Störparameter SP kann ein Störstrom IS gemäß der Figur 3 erzeugt werden, welcher anschließend den Betriebssprung gemäß der Figur 2 beaufschlagt wird. Wird nun die Stromsituation gemäß der Figur 2 mit der Stromsituation der Figur 3 kombiniert, so stellt sich ein Relationsstrom bzw. ein Kombinationsstrom ein, welcher die gewünschten disharmonischen Effekte an der jeweiligen Elektrode der Batterievorrichtung 100 aufweist, sodass aus chemischer und/oder physikalischer Sicht die entsprechende Schutzwirkung erzielt werden kann. Neben der Ausführung der Figuren 2 und 3 würde es grundsätzlich natürlich auch ausreichen, nur eine einzige Ausgestaltung des bzw. einen einzigen Stromparameter zwischen dem Betriebsstrom IB und dem Störstrom IS zu verändern.

Die Figur 4 zeigt schematisch die Ausführung einer Kontrollvorrichtung 10. Um die einzelnen Schritte der Bestimmung, der Ermittlung, der Erzeugung und der Beaufschlagung zu gewährleisten, ist die Kontrollvorrichtung 10 hier mit einem Bestimmungsmodul 20, einem Ermittlungsmodul 30, einem Erzeugungsmodul 40 sowie einem Beaufschlagungsmodul 50 ausgestattet. Als Eingangsgrößen und/oder zur Verwendung während der einzelnen Verfahrensschritte sind hier zusätzlich noch ein Simulationsmodell 110 sowie eine Sensorvorrichtung 120 vorgesehen.

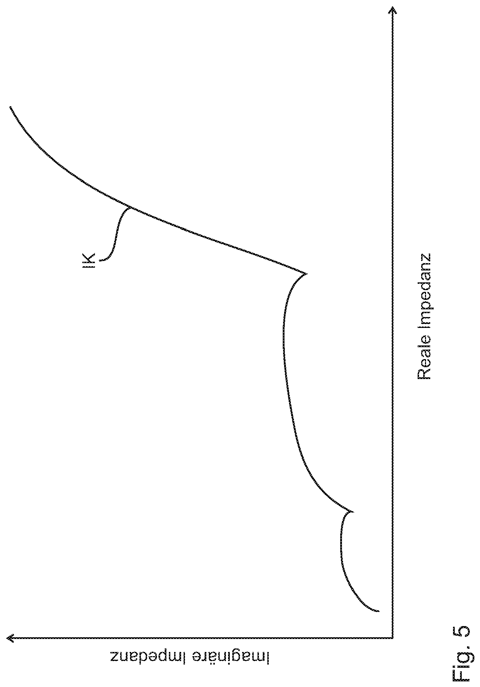

Eine Möglichkeit für die Auswahl eines entsprechenden Störparameters SP ist die Verwendung einer Impedanzkurve IK, wie sie die Figur 5 zeigt. Hier wird die reale Impedanz mit der imaginären Impedanz der Batterievorrichtung 100 korreliert. Wie der Figur 5 gut zu entnehmen ist, bilden sich hier zwei lokale Minima aus, welche bevorzugte Bereiche für die Auswahl des Störparameters SP sind. Insbesondere ist die Impedanzkurve IK (in Figur 5 nicht dargestellt) mit entsprechenden Frequenzbereichen gekoppelt, sodass auf Basis der Auswahl des lokalen Minimums auch eine Auswahl eines entsprechenden Frequenzbereiches als Störparameter SP für den Störstrom IS gewählt werden kann.

Die voranstehende Erläuterung der Ausführungsformen beschreibt die vorliegende Erfindung ausschließlich im Rahmen von Beispielen. Selbstverständlich können einzelne Merkmale der Ausführungsformen, sofern technisch sinnvoll, frei miteinander kombiniert werden, ohne den Rahmen der vorliegenden Erfindung zu verlassen.

### Bezugszeichen

- 10: Kontrollvorrichtung
- 20: Bestimmungsmodul
- 30: Ermittlungsmodul
- 40: Erzeugungsmodul
- 50: Beaufschlagungsmodul

- 100: Batterievorrichtung
- 110: Simulationsmodel
- 120: Sensorvorrichtung
- 130: Sekundärbauteil

- EBP: Batterieparameter
- BP: Betriebsparameter
- IB: Betriebsstrom
- SP: Störparameter
- IS: Störstrom
- IK: Impedanzkurve

## Patentansprüche

1. Verfahren zum Schutz einer Elektrode einer Batterievorrichtung (100) aufweisend die folgenden Schritte:
- Bestimmen wenigstens eines elektrischen Batterieparameters (EBP) der Batterievorrichtung (100), um eine jeweilige Batteriesituation der Batterievorrichtung (100) zu bestimmen,
- Bestimmen eines Betriebsparameters (BP) eines Betriebsstroms (IB) der Batterievorrichtung,
- Ermitteln eines Störparameters (SP) für einen Störstrom (IS) auf Basis des Betriebsparameters (BP),
- Erzeugen des Störstroms (IS),
- Beaufschlagen des Betriebsstroms (IB) mit dem Störstrom (IS) zum Anlegen an die Elektrode, um einen Alterungsprozess an der Elektrode zu hemmen oder um zumindest eine Geschwindigkeit einer Alterung der Elektrode zu reduzieren,
**dadurch gekennzeichnet, dass** für die Ermittlung des Störparameters (SP) ein Vergleich einer realen Impedanz der Batterievorrichtung (100) in der jeweiligen Batteriesituation und einer imaginären Impedanz basierend auf einer jeweiligen Simulation der Batterievorrichtung (100) in der jeweiligen Batteriesituation erfolgt.

2. Verfahren nach Anspruch 1, **dadurch gekennzeichnet, dass** die Bestimmung des wenigstens einen Betriebsparameters (BP) und/oder des wenigstens einen elektrischen Batterieparameters (EBP) zumindest teilweise auf Basis eines Simulationsmodels (110) erfolgt.

3. Verfahren nach Anspruch 1 oder 2, **dadurch gekennzeichnet, dass** der Störparameter (SP) eine Stromfrequenz des Störstroms (IS) aufweist, welche insbesondere kleiner oder im Wesentlichen kleiner als 1 kHz ist.

4. Verfahren nach einem der Ansprüche 1 bis 3, **dadurch gekennzeichnet, dass** beim Vergleich ein Bereich eines lokalen Minimums einer Impedanzkurve (IK) ausgewählt wird für die Ermittlung des Störparameters (SP), insbesondere in Form einer Stromfrequenz.

5. Verfahren nach einem der Ansprüche 1 bis 4, **dadurch gekennzeichnet, dass** für den Vergleich der realen Impedanz der Batterievorrichtung (100) in der jeweiligen Batteriesituation mit der imaginären Impedanz basierend auf einer jeweiligen Simulation der Batterievorrichtung (100) in der jeweiligen Batteriesituation eine für den bestimmten elektrischen Batterieparameter (EBP) und/oder den bestimmten Betriebsparameter (BP) spezifische Impedanzkurve (IK) verwendet wird, wobei die spezifische Impedanzkurve (IK) als Simulationsmodell zur Verfügung gestellt wird, und vorzugsweise durch Prüfstandsversuche erzeugt wird.

6. Verfahren nach einem der Ansprüche 1 bis 5, **dadurch gekennzeichnet, dass** bei der Ermittlung des Störparameters (SP) wenigstens eine absolute Grenze eingehalten wird.

7. Verfahren nach Anspruch 6, **dadurch gekennzeichnet, dass** als absolute Grenze für einen Störparameter (SP) in Form einer Stromamplitude als Obergrenze die Hälfte, insbesondere ein Drittel der aktuellen Stromamplitude des Betriebsstroms (IB) verwendet wird.

8. Verfahren nach einem der Ansprüche 1 bis 7, **dadurch gekennzeichnet, dass** für die Erzeugung des Störstroms (IS) wenigstens ein elektrisches Sekundärbauteil (130) mit eigenem Strombedarf im Stromkreis der Batterievorrichtung (100) eingesetzt wird.

9. Verfahren nach Anspruch 8, **dadurch gekennzeichnet, dass** als Sekundärbauteil (130) ein Inverter des Stromkreises der Batterievorrichtung (100) verwendet wird.

10. Verfahren nach einem der Ansprüche 8 oder 9, **dadurch gekennzeichnet, dass** wenigstens zwei Sekundärbauteile (130) wenigstens teilweise zeitlich parallel für das Erzeugen des Störstroms (IS) verwendet werden.

11. Verfahren nach Anspruch 10, **dadurch gekennzeichnet, dass** die wenigstens zwei Sekundärbauteile (130) mit synchronem oder im Wesentlichen synchronem Störstrom (IS) betrieben werden.

12. Verfahren nach Anspruch 10, **dadurch gekennzeichnet, dass** die wenigstens zwei Sekundärbauteile (130) mit asynchronem oder im Wesentlichen asynchronem Störstrom (IS) betrieben werden.

13. Kontrollvorrichtung (10) für die Kontrolle einer Batterievorrichtung (100), aufweisend ein Bestimmungsmodul (20) zum Bestimmen wenigstens eines elektrischen Batterieparameters (EBP) der Batterievorrichtung (100), um eine jeweilige Batteriesituation der Batterievorrichtung (100) zu bestimmen, und zum Bestimmen eines Betriebsparameters (BP) eines Betriebsstroms (IB) der Batterievorrichtung, ein Ermittlungsmodul (30) zum Ermitteln eines Störparameters (SP) für einen Störstrom (IS) auf Basis des Betriebsparameters (BP), wobei für die Ermittlung des Störparameters (SP) ein Vergleich der realen Impedanz der Batterievorrichtung (100) in der jeweiligen Batteriesituation und der imaginären Impedanz basierend auf einer jeweiligen Simulation der Batterievorrichtung (100) in der jeweiligen Batteriesituation erfolgt, ein Erzeugungsmodul (40) zum Erzeugen des Störstroms (IS) und ein Beaufschlagungsmodul (50) für ein Beaufschlagen des Betriebsstroms (IB) mit dem Störstrom (IS) zum Anlegen an eine Elektrode der Batterievorrichtung (100), um einen Alterungsprozess an der Elektrode zu hemmen oder um zumindest eine Geschwindigkeit einer Alterung der Elektrode zu reduzieren.

14. Kontrollvorrichtung (10) nach Anspruch 13, **dadurch gekennzeichnet, dass** das Bestimmungsmodul (20), das Ermittlungsmodul (30), das Erzeugungsmodul (40) und das Beaufschlagungsmodul (50) für die Durchführung eines Verfahrens mit den Merkmalen eines der Ansprüche 1 bis 12 ausgebildet ist.

15. Computerprogrammprodukt, umfassend Befehle, die bei der Ausführung des Programms durch einen Computer diesen Veranlassen das Verfahren mit den Merkmalen eines der Ansprüche 1 bis 12 durch die Kontrollvorrichtung (10) nach Anspruch 13 oder 14 auszuführen.

## Claims

1. A method for protecting an electrode of a battery device (100), comprising the following steps:
determining at least one electrical battery parameter (EBP) of the battery device (100) in order to determine a respective battery situation of the battery device (100),
determining an operating parameter (BP) of an operating current (IB) of the battery device,
ascertaining a disturbance parameter (SP) for a disturbance current (IS) based on the operating parameter (BP),
generating the disturbance current (IS),
superimposing the disturbance current (IS) on the operating current (IB) for application to the electrode in order to inhibit an aging process at the electrode or in order to at least reduce a rate of aging of the electrode,
**characterized in that** for the ascertainment of the disturbance parameter (SP), a comparison of a real impedance of the battery device (100) in the respective battery situation and an imaginary impedance based on a respective simulation of the battery device (100) in the respective battery situation is performed.

2. The method according to claim 1, **characterized in that** the determination of the at least one operating parameter (BP) and/or of the at least one electrical battery parameter (EBP) is performed at least partially based on a simulation model (110).

3. The method according to claim 1 or 2, **characterized in that** the disturbance parameter (SP) has a current frequency of the disturbance current (IS) which is in particular less than or substantially less than 1 kHz.

4. The method according to any one of claims 1 to 3, **characterized in that** during the comparison, a region of a local minimum of an impedance curve (IK) is selected for the ascertainment of the disturbance parameter (SP), in particular in the form of a current frequency.

5. The method according to any one of claims 1 to 4, **characterized in that** for the comparison of the real impedance of the battery device (100) in the respective battery situation with the imaginary impedance based on a respective simulation of the battery device (100) in the respective battery situation, an impedance curve (IK) specific to the determined electrical battery parameter (EBP) and/or the determined operating parameter (BP) is used, wherein the specific impedance curve (IK) is provided as a simulation model, and is preferably generated by test bench tests.

6. The method according to any one of claims 1 to 5, **characterized in that** during the ascertainment of the disturbance parameter (SP), at least one absolute limit is adhered to.

7. The method according to claim 6, **characterized in that**, as an absolute limit for a disturbance parameter (SP) in the form of a current amplitude, half, in particular one third, of the present current amplitude of the operating current (IB) is used as an upper limit.

8. The method according to any one of claims 1 to 7, **characterized in that** for the generation of the disturbance current (IS), at least one electrical secondary component (130) with its own current requirement is used in the circuit of the battery device (100).

9. The method according to claim 8, **characterized in that** an inverter of the circuit of the battery device (100) is used as the secondary component (130).

10. The method according to claim 8 or 9, **characterized in that** at least two secondary components (130) are used at least partially temporally in parallel for generating the disturbance current (IS).

11. The method according to claim 10, **characterized in that** the at least two secondary components (130) are operated with a synchronous or substantially synchronous disturbance current (IS).

12. The method according to claim 10, **characterized in that** the at least two secondary components (130) are operated with an asynchronous or substantially asynchronous disturbance current (IS).

13. A control device (10) for controlling a battery device (100), comprising a determining module (20) for determining at least one electrical battery parameter (EBP) of the battery device (100) in order to determine a respective battery situation of the battery device (100), and for determining an operating parameter (BP) of an operating current (IB) of the battery device, an ascertaining module (30) for ascertaining a disturbance parameter (SP) for a disturbance current (IS) based on the operating parameter (BP), wherein for the ascertainment of the disturbance parameter (SP), a comparison of the real impedance of the battery device (100) in the respective battery situation and the imaginary impedance based on a respective simulation of the battery device (100) in the respective battery situation is performed, a generating module (40) for generating the disturbance current (IS) and a superimposing module (50) for superimposing the disturbance current (IS) on the operating current (IB) for application to an electrode of the battery device (100) in order to inhibit an aging process at the electrode or in order to at least reduce a rate of aging of the electrode.

14. The control device (10) according to claim 13, **characterized in that** the determining module (20), the ascertaining module (30), the generating module (40) and the superimposing module (50) are configured for performing a method having the features of any one of claims 1 to 12.

15. A computer program product comprising instructions which, when the program is executed by a computer, cause the computer to carry out the method having the features of any one of claims 1 to 12 by means of the control device (10) according to claim 13 or 14.

## Revendications

1. Procédé de protection d'une électrode d'un dispositif de batterie (100) comprenant les étapes suivantes :
détermination d'au moins un paramètre électrique de batterie (EBP) du dispositif de batterie (100), afin de déterminer une situation de batterie respective du dispositif de batterie (100),
détermination d'un paramètre de fonctionnement (BP) d'un courant de fonctionnement (IB) du dispositif de batterie,
établissement d'un paramètre de perturbation (SP) pour un courant de perturbation (IS) sur la base du paramètre de fonctionnement (BP),
génération du courant de perturbation (IS),
superposition du courant de perturbation (IS) et courant de fonctionnement (IB) pour son application à l'électrode, afin d'inhiber un processus de vieillissement au niveau de l'électrode ou d'au moins réduire une vitesse de vieillissement de l'électrode,
**caractérisé en ce que,** pour l'établissement du paramètre de perturbation (SP), une comparaison entre une impédance réelle du dispositif de batterie (100) dans la situation de batterie respective et une impédance imaginaire basée sur une simulation respective du dispositif de batterie (100) dans la situation de batterie respective est effectuée.

2. Procédé selon la revendication 1, **caractérisé en ce que** la détermination de l'au moins un paramètre de fonctionnement (BP) et/ou de l'au moins un paramètre électrique de batterie (EBP) est effectuée au moins partiellement sur la base d'un modèle de simulation (110).

3. Procédé selon la revendication 1 ou 2, **caractérisé en ce que** le paramètre de perturbation (SP) présente une fréquence de courant du courant de perturbation (IS), laquelle est notamment inférieure ou sensiblement inférieure à 1 kHz.

4. Procédé selon l'une quelconque des revendications 1 à 3, **caractérisé en ce que**, lors de la comparaison, une plage d'un minimum local d'une courbe d'impédance (IK) est sélectionnée pour l'établissement du paramètre de perturbation (SP), notamment sous la forme d'une fréquence de courant.

5. Procédé selon l'une quelconque des revendications 1 à 4, **caractérisé en ce que**, pour la comparaison de l'impédance réelle du dispositif de batterie (100) dans la situation de batterie respective avec l'impédance imaginaire basée sur une simulation respective du dispositif de batterie (100) dans la situation de batterie respective, une courbe d'impédance (IK) spécifique au paramètre électrique de batterie (EBP) déterminé et/ou au paramètre de fonctionnement (BP) déterminé est utilisée, où la courbe d'impédance (IK) spécifique étant mise à disposition en tant que modèle de simulation, et étant de préférence générée par des essais sur banc d'essai.

6. Procédé selon l'une quelconque des revendications 1 à 5, **caractérisé en ce que**, lors de l'établissement du paramètre de perturbation (SP), au moins une limite absolue est respectée.

7. Procédé selon la revendication 6, **caractérisé en ce que**, comme limite absolue pour un paramètre de perturbation (SP) sous la forme d'une amplitude de courant, la moitié, notamment un tiers, de l'amplitude de courant actuelle du courant de fonctionnement (IB) est utilisée en tant que limite supérieure.

8. Procédé selon l'une quelconque des revendications 1 à 7, **caractérisé en ce que**, pour la génération du courant de perturbation (IS), au moins un composant électrique secondaire (130) ayant un besoin propre en courant est mis en œuvre dans le circuit électrique du dispositif de batterie (100).

9. Procédé selon la revendication 8, **caractérisé en ce que**, en tant que composant secondaire (130), un onduleur du circuit électrique du dispositif de batterie (100) est utilisé.

10. Procédé selon l'une des revendications 8 ou 9, **caractérisé en ce qu'**au moins deux composants secondaires (130) sont utilisés au moins partiellement en parallèle dans le temps pour la génération du courant de perturbation (IS).

11. Procédé selon la revendication 10, **caractérisé en ce que** les au moins deux composants secondaires (130) sont exploités avec un courant de perturbation (IS) synchrone ou sensiblement synchrone.

12. Procédé selon la revendication 10, **caractérisé en ce que** les au moins deux composants secondaires (130) sont exploités avec un courant de perturbation (IS) asynchrone ou sensiblement asynchrone.

13. Dispositif de contrôle (10) pour le contrôle d'un dispositif de batterie (100), comprenant un module de détermination (20) pour déterminer au moins un paramètre électrique de batterie (EBP) du dispositif de batterie (100), afin de déterminer une situation de batterie respective du dispositif de batterie (100), et pour déterminer un paramètre de fonctionnement (BP) d'un courant de fonctionnement (IB) du dispositif de batterie, un module d'établissement (30) pour établir un paramètre de perturbation (SP) pour un courant de perturbation (IS) sur la base du paramètre de fonctionnement (BP), où, pour l'établissement du paramètre de perturbation (SP), une comparaison entre l'impédance réelle du dispositif de batterie (100) dans la situation de batterie respective et l'impédance imaginaire basée sur une simulation respective du dispositif de batterie (100) dans la situation de batterie respective est effectuée, un module de génération (40) pour générer le courant de perturbation (IS) et un module de superposition (50) pour superposer le courant de perturbation (IS) au courant de fonctionnement (IB) en vue de son application à une électrode du dispositif de batterie (100), afin d'inhiber un processus de vieillissement au niveau de l'électrode ou d'au moins réduire une vitesse de vieillissement de l'électrode.

14. Dispositif de contrôle (10) selon la revendication 13, **caractérisé en ce que** le module de détermination (20), le module d'établissement (30), le module de génération (40) et le module de superposition (50) sont conçus pour la mise en œuvre d'un procédé présentant les caractéristiques de l'une quelconque des revendications 1 à 12.

15. Produit programme d'ordinateur, comprenant des instructions qui, lors de l'exécution du programme par un ordinateur, amènent celui-ci à exécuter le procédé présentant les caractéristiques de l'une quelconque des revendications 1 à 12 par le dispositif de contrôle (10) selon la revendication 13 ou 14.
